# EUROPÄISCHE PATENTSCHRIFT

(11) **EP 0 567 799 B1**
(45) Veröffentlichungstag und Bekanntmachung des Hinweises auf die Patenterteilung: **14.08.1996**
(21) Anmeldenummer: 93105480.3
(22) Anmeldetag: 02.04.1993
(51) Int. Cl.: H03M 13/00

(54) **Gerät zum Empfang von Daten**
Apparatus for data reception
Appareil pour la réception de données

(30) Priorität: 29.04.1992 DE 4214015
(43) Veröffentlichungstag der Anmeldung: 03.11.1993
(73) Patentinhaber: Blaupunkt-Werke GmbH, D-31132 Hildesheim (DE)
(72) Erfinder: Hegeler, Wilhelm, W-3200 Hildesheim (DE)

(56) Entgegenhaltungen:
- EP-A- 0 280 913
- EP-A- 0 439 649

## Beschreibung

Die Erfindung geht aus von einem Gerät nach der Gattung des Hauptanspruchs, wobei die Daten mittels Radiowellen, insbesondere zusammen mit anderen Informationen, übertragen werden.

Der Empfang solcher Daten kann in vielfältiger Weise gestört sein. Es sind daher Verfahren und Geräte zur Feststellung und/oder Korrektur von Übertragungsfehlern bekanntgeworden. Bei dem sogenannten Radiodatensystem (RDS) wird ein Hilfsträger mit digital-codierten Signalen moduliert, und zwar werden die Daten in Gruppen von jeweils vier Datenworten übertragen, wobei jeweils ein Datenwort aus einem Informationswort von 16 Bits und einem Prüfwort von 10 Bits besteht. Das Prüfwort wird bei dem Radiodatensystem nach einem vorgegebenen Algorithmus aus dem Informationswort gebildet, wobei dem eigentlichen Prüfwort noch ein sogenanntes Offset-Wort überlagert wird, das zur Synchronisierung dient.

Beim Empfang wird nach der Demodulation mit Hilfe des Prüfwortes eine Fehlerprüfung sowie eine Fehlerkorrektur vorgenommen. Eine ausführliche Beschreibung des Radiodatensystems RDS liegt in der Druckschrift vor: "Specifications of the Radio Data System RDS for VHF/FM Sound Broadcasting", Tech. 3244 - E, März 1984, herausgegeben von der European Broadcasting Union (EBU).

Bei einem bekannten Gerät zum Empfang von Daten (DE 37 07 152 A1) wird zusätzlich zu dieser Fehlerprüfung und -korrektur ein binäres Zuverlässigkeitssignal abgeleitet, bei welchem jeweils 1 Bit innerhalb eines Zuverlässigkeitswortes einem Bit des Datenwortes zugeordnet ist.

Die bekannte Fehlerkorrektur ist eine sogenannte Löschkorrektur, das heißt, nur als schlecht bzw. verdächtig gekennzeichnete Bits sind zur Modifikation zwecks Korrektur zugelassen. Dabei werden alle Kombinationen mit Ausnahme der Null-Kombination daraufhin geprüft, ob das aus der betreffenden Kombination resultierende Syndrom entweder dem vorgefundenen Fehlersyndrom entspricht (dann ist eine Korrektur möglich) oder den Wert Null hat (dann ist die Korrektur nicht eindeutig). Deshalb unterbleibt im letzteren Fall die Korrektur. Hierbei führen falsche, aber als gut gekennzeichnete Bits zu einem nicht richtig korrigierbaren Block.

Aufgabe der vorliegenden Erfindung ist es zu vermeiden, daß falsche, aber im Zuverlässigkeitswort als gut bezeichnete Bits zu einer falschen Korrektur führen.

Das erfindungsgemäße Gerät mit den kennzeichnenden Merkmalen des Hauptanspruchs hat den Vorteil, daß nur mit äußerst geringem Mehraufwand eine wesentliche Verbesserung der Fehlerkorrektur möglich ist. Die Anzahl der auftretenden Fehlkorrekturen kann dabei erheblich gesenkt werden.

Durch die in den Unteransprüchen aufgeführten Maßnahmen sind vorteilhafte Weiterbildungen und Verbesserungen der im Hauptanspruch angegebenen Erfindung möglich.

Ausführungsbeispiele der Erfindung sind in der Zeichnung anhand mehrerer Figuren dargestellt und in der nachfolgenden Beschreibung näher erläutert. Es zeigt:
- Fig. 1: ein Blockschaltbild eines erfindungsgemäßen Gerätes,
- Fig. 2: eine schematische Darstellung der Ableitung eines Syndroms,
- Fig. 3: eine tabellarische Darstellung zur Erläuterung der Ableitung der Kombinationen weiterer Syndrome,
- Fig. 4: ein Flußdiagramm für einen in einem erfindungsgemäßen Gerät enthaltenen Mikrocomputer,
- Fig. 5: ein Detail des Flußdiagramms nach Fig. 4 und
- Fig. 6: ein Blockschaltbild einer Anordnung zur Auswertung der Syndrome und zur Fehlerkorrektur.

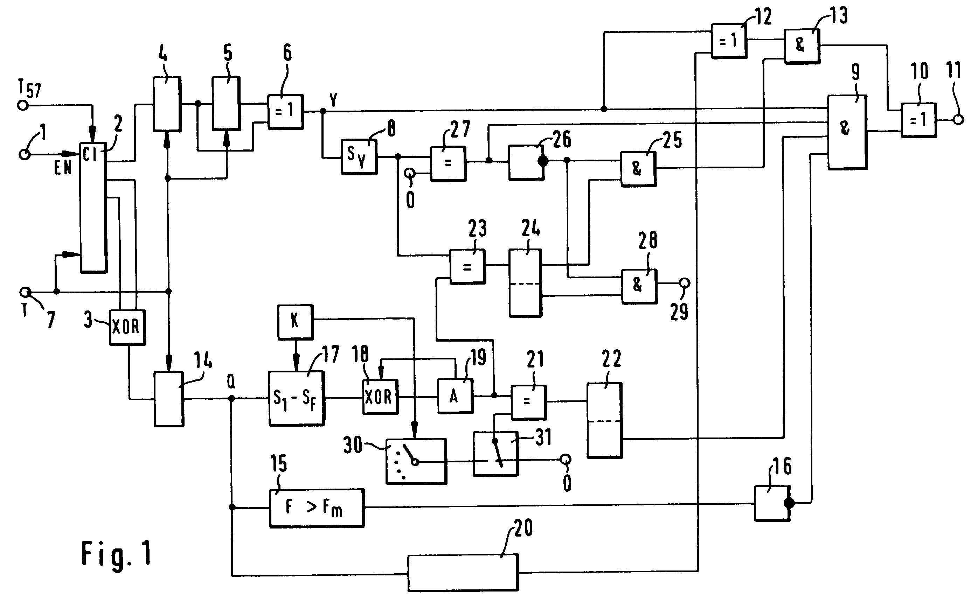

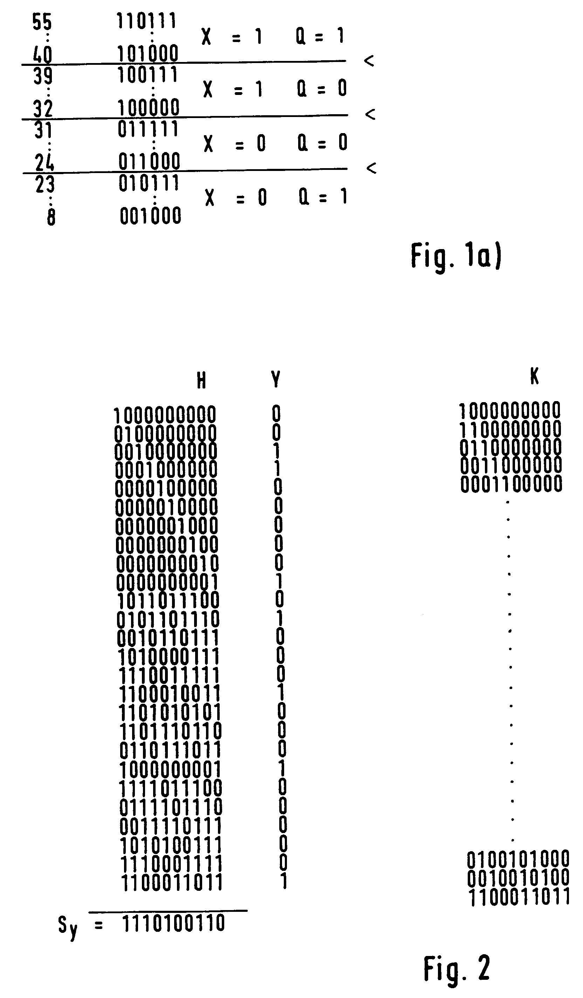

Das Blockschaltbild gemäß Fig. 1 zeigt in stark vereinfachter Weise ein erfindungsgemäßes Gerät, wobei lediglich die zum Verständnis erforderlichen Teile dargestellt sind. Weitere Einzelheiten, beispielsweise bei der Demodulation und der Wort- bzw. Bitsynchronisierung, sind in der Literatur, insbesondere in der eingangs genannten Veröffentlichung der EBU, ausreichend beschrieben. Ferner wurde der Übersichtlichkeit halber bei der Darstellung gemäß Fig. 1 auf den zeitlichen Ablauf bei der Signalverarbeitung im einzelnen nicht Rücksicht genommen.

Dieser wird im Zusammenhang mit anderen Figuren genauer erläutert.

Das Ausgangssignal eines nicht dargestellten Demodulators wird über den Eingang 1 dem Freigabe(Enable)-Eingang eines 6-Bit-Zählers 2 zugeführt. Der 6-Bit-Zähler 2 wird mit einem Signal T₅₇ getaktet, dessen Frequenz bei dem Ausführungsbeispiel der Hilfsträgerfrequenz von 57 kHz entspricht. Mit dem bei 7 zugeführten Bit-Takt T wird der 6-Bit-Zähler 2 auf einen Anfangswert gesetzt. Der jeweils vor dem Setzen erreichte Zählerstand ergibt nach der in Fig. 1a) dargestellten Tabelle ein Datensignal X und ein Zuverlässigkeitssignal Q. Dabei wird der Zähler auf den Anfangswert 8 gesetzt und zählt bis 55, also um 48 weiter, da beim RDS-System die Hilfsträgerfrequenz dem 48-fachen der Bitfrequenz entspricht.

Die Schwelle zur Bildung des Datensignals X liegt bei der Tabelle nach Fig. 1a) in der Mitte des Gesamtbereichs, so daß das höchstwertige Bit (MSB) des Zählerstandes direkt als Datensignal X verwendet werden kann. Die obere und die untere Schwelle für das Zuverlässigkeitssignal schließen die Schwelle für das Datensignal ein. Zwischen der oberen und der unteren Schwelle sind jeweils das zweite und das dritte Bit des Zählerstandes gleich, während unterhalb bzw. oberhalb dieser Schwellen das zweite und das dritte Bit verschieden sind. Es ist daher möglich, mit Hilfe einer Exklusiv-Oder-Schaltung 3 das Zuverlässigkeitssignal Q abzuleiten.

Die am Ende jeweils einer Bitperiode nur kurzzeitig anstehenden Bits des Datensignals X werden einem aus zwei Daten-Flip-Flops 4 und 5 sowie einer Exklusiv-Oder-Schaltung 6 bestehenden Differentialdecoder zugeführt. Die Flip-Flops werden mit dem bei 7 zugeführten Bit-Takt T getriggert, so daß mit Hilfe der Daten-Flip-Flops 4, 5 das binäre Signal jeweils um eine Taktperiode verzögert wird. Die Exklusiv-Oder-Schaltung 6 gibt eine 1 ab, wenn zwei aufeinanderfolgende Bits des empfangenen Signals verschiedene Werte aufweisen.

Bei dem Radiodatensystem werden die Informationen in Datenworten gesendet, von denen jeweils vier eine Gruppe bilden. Jedes der Datenworte besteht aus einem Informationswort mit 16 Bits und einem Prüfwort von 10 Bits, so daß die gesamte Länge des Datenwortes 26 Bits beträgt.

Aus dem am Ausgang des Differentialdecoders anstehenden Datenwort Y wird in an sich bekannter Weise bei 8 ein Syndrom S_{Y} gebildet. In Abhängigkeit vom Wert dieses Syndroms sowie der Werte weiterer Syndrome wird das Datenwort Y bzw. dessen Informationsteil entweder direkt oder über die UND-Schaltung 9 und die Oder-Schaltung 10 zum Ausgang 11 geleitet, von dem es zur weiteren Verarbeitung, beispielsweise für eine Anzeige, geleitet werden kann, oder zurückgehalten wird, wenn es unbrauchbar ist. Für den Fall von korrigierbaren Fehlern wird das Datenwort mit Hilfe der Exklusiv-Oder-Schaltung 12 korrigiert und über die UND-Schaltung 13 und die Oder-Schaltung 10 zum Ausgang 11 geleitet.

An den Ausgang der Exklusiv-Oder-Schaltung 3 ist ein Daten-Flip-Flop 14 angeschlossen, welches ebenfalls mit dem bei 7 zugeführten Takt T getaktet wird. Am Ausgang des Daten-Flip-Flops 14 steht dann ein digitales Signal Q an, bei welchem jeweils ein Bit einem Bit des Signals Y zugeordnet ist. Dieses Signal kennzeichnet die Zuverlässigkeit bzw. die Unzuverlässigkeit der einzelnen Bits des Signals Y vor der Differentialcodierung.

Da der Aufwand für die Auswertung des Zuverlässigkeitssignals stark mit der Anzahl der Unzuverlässigkeitsbits ansteigt und außerdem wegen der geringen Hamming-Distanz des für das Radiodatensystem gewählten Codes eine Korrektur vieler Fehler ohnehin nicht möglich ist, wird von vornherein die Auswertung eines Datenwortes, bei welchem das Zuverlässigkeitswort zuviele Unzuverlässigkeitsbits enthält, abgebrochen. Bei dem Ausführungsbeispiel gemäß Fig. 1 wird daher in einer Zähl- und Vergleichsschaltung 15 festgestellt, ob die Zahl F der Unzuverlässigkeitsbits größer als ein vorgegebener Wert Fₘ ist, wobei für Fₘ beispielsweise der Wert 6 in Frage kommt. Ist dieses der Fall, so wird von der Schaltung 15 eine 1 abgegeben, welche bei 16 invertiert wird, so daß die Weiterleitung des Datenwortes durch die UND-Schaltung 9 unterbunden wird - unabhängig davon, was die Auswertung im einzelnen ergibt.

Für jedes Unzuverlässigkeitsbit wird aus einer Matrix K ein Syndrom abgerufen, in einem Speicher 17 abgelegt und in einer Exklusiv-Oder-Schaltung 18 mit einem anderen Syndrom verknüpft, welches sich im Akkumulator 19 befindet. Sobald eine der Kombinationen den Wert 0 aufweist, was in einer Äquivalenzschaltung 21 festgestellt wird, wird ein Flip-Flop 22 gesetzt. Das Ausgangssignal des Flip-Flops verhindert über die UND-Schaltung 9 ebenfalls die Weiterleitung des Datenwortes zum Ausgang 11.

Zusätzlich wird der jeweilige Inhalt des Akkumulators 19 mit allen Zeilen der Matrix K verglichen, wenn mehr als eines der Syndrome S₁ bis S_{F} am Inhalt des Akkumulators A beteiligt sind, wenn also mehr als ein Unzuverlässigkeitsbit in der betreffenden Kombination verwendet wurden. Dieser Vergleich erfolgt bei dem Gerät nach Fig. 1 durch eine Einrichtung 30, welche nacheinander die einzelnen Zeilen der Matrix K über einen Umschalter 31 der Äquivalenzschaltung 21 zuführt. Dieser zusätzliche Vergleich darf bei der Beteiligung von nur einem Syndrom an dem Akkumulatorinhalt keine Folgen haben, da der Inhalt des Akkumulators immer gleich einer Zeile der Matrix K ist. Deshalb ist es aus Gründen des Rechenaufwandes vorteilhaft, den weiteren Vergleich nur vorzunehmen, wenn mehrere der Syndrome S₁ bis S_{F} zum Inhalt des Akkumulators A beitragen. Wenn irgendeine der Kombinationen der weiteren Syndrome also den Wert 0 aufweist oder im Falle mehrerer weiterer Syndrome einer Zeile der Matrix K entspricht, wird das Datenwort somit für ungültig erklärt.

In einer weiteren Äquivalenzschaltung 23 wird geprüft, ob eines der Syndrome dem Syndrom S_{Y} des Datenwortes entspricht. Ist dieses der Fall, so wird das Flip-Flop 24 gesetzt, dessen nichtinvertiertes Ausgangssignal mit Hilfe einer UND-Schaltung 25 mit dem bei 26 invertierten Ausgangssignal einer Äquivalenzschaltung 27 verknüpft wird. Am Ausgang der UND-Schaltung 25 steht dann eine 1 an, wenn eine der Kombinationen der weiteren Syndrome S₁ bis S_{F} dem Syndrom S_{Y} des Datenwortes Y entspricht und wenn keine Kombination bzw. das Syndrom S_{Y} nicht gleich 0 ist und die oben beschriebene Prüfung negativ verlaufen ist. In diesem Fall wird die UND-Schaltung 13 leitend und ein korrigiertes Datenwort wird zum Ausgang 11 geleitet. Zur Korrektur dient ein mit Hilfe der Schaltung 20 abgeleitetes Fehlerwort, das bei 12 mit dem Datenwort exklusiv-oder-verknüpft wird. Ein Beispiel für die Schaltung 20 ist in DE 37 07 152 A1 näher erläutert.

Ist keine der Kombinationen der weiteren Syndrome gleich dem Syndrom S_{Y} des Datenwortes, so bleibt das Flip-Flop 24 ungesetzt und gibt an seinem invertierenden Ausgang eine 1 an die UND-Schaltung 28 ab, an deren Ausgang ein Signal ansteht, wenn außerdem das Syndrom S_{Y} ungleich 0 ist. Dieses bedeutet, daß das Datenwort Y nicht korrigierbar ist.

In der folgenden Tabelle sind die im Zusammenhang mit Fig. 1 beschriebenen verschiedenen Möglichkeiten zusammengestellt:

| | | |
|---|---|---|
| F > Fₘ | Wort ungültig | --> keine Bearbeitung |
| F ≤ Fₘ | (a) irgendeine XOR-Kombination | |
| | der Syndrome S₁ bis S_{F} = 0 | --> Wort ungültig |
| | (b) irgendeine XOR-Kombination mindestens zweier | |
| | Syndrome S₁ bis S_{F} = irgendeiner Zeile der Matrix K | --> Wort ungültig |
| | (c) wenn weder (a) noch (b) | |
| | keine Kombination = S_{Y} | |
| | S_{Y} = 0 | --> Y in Ordnung |
| | S_{Y} ungleich 0 | --> Y nicht korrigierbar |
| | eine Kombination = S_{Y} | |
| | S_{Y} ungleich 0 | --> Y korrigierbar |

Zur Erläuterung der Syndrombildung ist in Fig. 2 die in der obengenannten EBU-Veröffentlichung vorgeschlagene Paritätsprüfmatrix H sowie ein Beispiel eines Datenwortes Y und des aus diesem Datenwort und der Matrix H gebildeten Syndroms S_{Y} dargestellt. Die Matrix H besteht aus 26 Zeilen mit jeweils 10 Spalten. Die Berechnung des Syndroms S_{Y} für das Datenwort Y erfolgt nun derart, daß alle Zeilen der Matrix H miteinander exklusiv-oder-verknüpft werden, bei welchen das Datenwort den Wert 1 aufweist. Durch die mehrfache Exklusiv-Oder-Verknüpfung ergibt sich bekanntlich bei Vorliegen einer ungeraden Anzahl von Einsen eine 1 und bei einer geraden Anzahl von Einsen eine 0.

Durch die Differential-Codierung entstehen aus einem 1-Bit-Fehler des Signals auf der Übertragungsstrecke 2-Bit-Fehler bei dem Datenwort Y. Bei der Erzeugung des Zuverlässigkeitswortes Q wird die Dauer der Fehler auf der Übertragungsstrecke nicht vergrößert, so daß jeweils ein einzelnes Unzuverlässigkeitsbit auf einen 1-Bit-Fehler auf der Übertragungsstrecke, also auf einen 2-Bit-Fehler im Datenwort Y hinweist. Aus diesem Grunde erfolgt die Syndrombildung aus den Unzuverlässigkeitsbits mit Hilfe einer Matrix K, welche in Fig. 2 teilweise dargestellt und aus der Matrix H wie folgt abgeleitet ist: Die erste und die letzte Zeile entsprechen der Matrix H, während die dazwischenliegenden Zeilen jeweils durch eine Exklusiv-Oder-Verknüpfung der benachbarten Zeilen der H-Matrix gebildet sind. Die Matrix K weist somit 27 Zeilen auf. Dieses ermöglicht die Berücksichtigung des letzten Bits des vorangegangenen Zuverlässigkeitswortes.

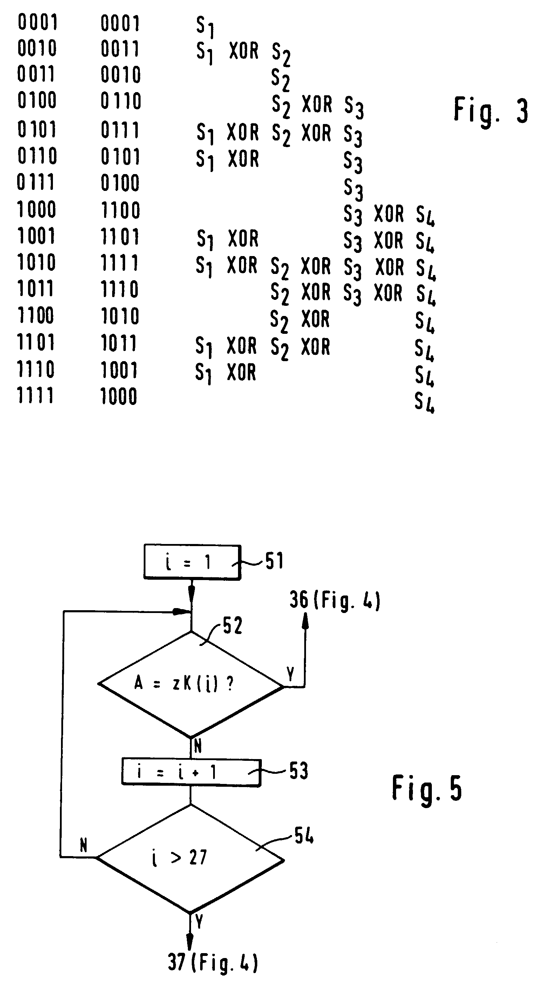

Mit Hilfe der Matrix K werden die Syndrome aller einzelnen Unzuverlässigkeitsbits gebildet und bei 17 (Fig. 1) abgespeichert. Der Rechenaufwand zur Exklusiv-Oder-Verknüpfung der Syndrome S₁ bis S_{F} kann erheblich reduziert werden, wenn gemäß Fig. 3 vorgegangen wird.

Es wird dabei von maximal vier auszuwertenden Unzuverlässigkeitsbits ausgegangen. Die Zahl n stellt eine Zählvariable dar, aus welcher nach einem Gray-Code die Zahl z errechnet wird, die jweils angibt, welche der weiteren Syndrome S₁ bis S₄ exklusiv-oder zu verknüpfen sind. Der Einfachheit halber wurde eine Exklusiv-Oder-Verknüpfung in der Zeichnung durch die Abkürzung XOR dargestellt. Dabei bewirkt die Anwendung des Gray-Codes, bei dem sich von Zeile zu Zeile immer nur ein Bit ändert, daß vom Speicher 17 in die Exklusiv-Oder-Verknüpfung 18 für jeden neuen Rechenschritt nur ein neues Syndrom übernommen wird. Dabei wird bei n = 15 das Syndrom S₄ ohne Verknüpfung an den Ausgang der Schaltung 19 (Fig. 1) weitergeleitet; bei n = 14 (= 1110) werden die Syndrome bis S₁ und S₄ miteinander verknüpft, danach wird zusätzlich das Syndrom S₂ aus dem Speicher gelesen und mit den Syndromen S₁ und S₄ verknüpft usw.. Aus jeder Kombination entsteht durch eine einzige Exklusiv-Oder-Verknüpfung eine neue Kombination.

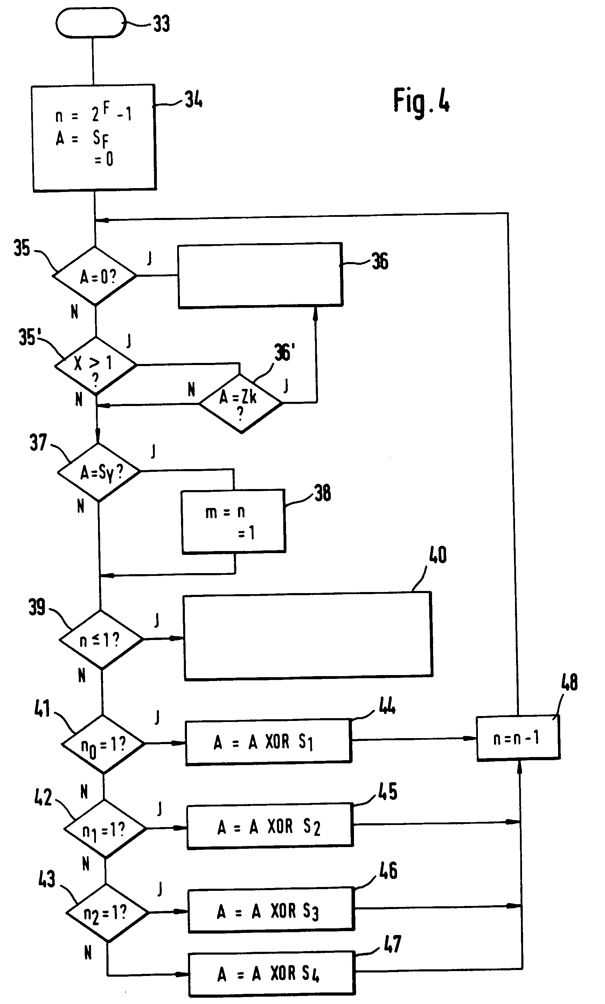

Fig. 4 zeigt ein Flußdiagramm für die im Zusammenhang mit Fig. 3 erläuterte Kombination der weiteren Syndrome. Nach dem Start des Programms bei 33 wird bei 34 die Zählvariable n auf die Zahl der möglichen Kombinationen bei F Unzuverlässigkeitsbits gesetzt. Außerdem wird in einem Akkumulator A das Syndrom S_{F} eingelesen und ein Merker (Flag) = 0 gesetzt. Danach wird bei 35 geprüft, ob der Inhalt des Akkumulators, also beim ersten Programmdurchlauf das Syndrom S_{F} gleich 0 ist. Ist dieses der Fall, wird die Prüfung bei 36 abgebrochen.

Ist der Inhalt des Akkumulators A ungleich 0, wird geprüft, ob die Anzahl x der Einsen in der Gray-codierten Zählvariablen n größer als 1 ist. Trifft dieses zu, verzweigt sich das Programm bei 36' in Abhängigkeit davon, ob A einer der Zeilen der Matrix K entspricht. Wenn ja, wird bei 36 die Prüfung abgebrochen, anderenfalls bei 37 fortgesetzt.

Bei 37 wird geprüft, ob der Inhalt des Akkumulators mit dem Syndrom S_{Y} übereinstimmt. Zutreffendenfalls wird der Merker auf 1 und eine Zahl m gleich der Zahl n gesetzt. Letzteres dient dazu, beim späteren Ende der Prüfung diejenige Kombination festgehalten zu haben, bei welcher A = S_{Y} ist.

Bei 39 wird geprüft, ob die Zählvariable n den Wert 1 erreicht hat. Wenn dieses der Fall ist und der Merker auf 1 gesetzt ist, wird bei 40 die Zahl m zur Korrektur des Datenwortes ausgegeben.

Solange n noch nicht den Wert 1 erreicht hat, wird mit Hilfe der Programmschritte 41 bis 43 jeweils geprüft, ob jeweils eines der Bits n₀ bis n₂ (n₀ = LSB) der Dualzahl n den Wert 1 hat. Damit erfolgt eine Aufteilung des weiteren Programmablaufs nach einem Gray-Code zu den Exklusiv-Oder-Verknüpfungen 44 bis 47. In diesen Programmteilen wird jeweils der Inhalt A des Akkumulators durch Exklusiv-Oder-Verknüpfung des vorangegangenen Akkumulatorinhalts mit einem der Syndrome S₁ bis S₄ ermittelt. Danach wird die Zählvariable n bei 48 dekrementiert und das Programm bei 35 fortgesetzt.

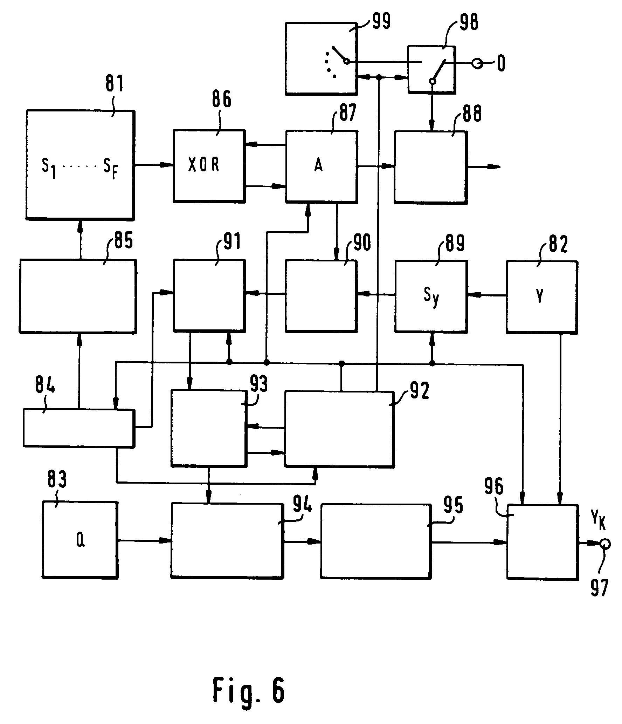

Fig. 5 stellt den Programmteil 36' (Fig. 4) etwas detaillierter dar. Zu Beginn wird eine die jeweilige Zeile der Matrix K darstellende Zählvariable i auf 1 gesetzt (Programmteil 51). Danach wird bei 52 geprüft, ob die Zeile mit der Nummer i dem Inhalt des Akkumulators entspricht. Zutreffendenfalls wird die Prüfung bei 36 (Fig. 4) abgebrochen. Anderenfalls wird bei 53 die Zählvariable i inkrementiert und danach mit der Anzahl der Zeilen der Matrix K, nämlich 27, verglichen. Daraufhin werden die Programmschritte 52, 53, 54 solange wiederholt, bis entweder eine Zeile der Matrix K dem Akkumulatorinhalt entspricht oder bis die Zeile 27 erreicht ist. Dann wird der Korrekturversuch entweder bei 36 abgebrochen oder bei 37 (Fig. 4) fortgesetzt.

Fig. 6 zeigt ein Blockschaltbild einer Anordnung zur Auswertung der Syndrome S_{Y} und S₁ bis S_{F}. Dabei sind die Syndrome S₁ bis S_{F} in einem Speicher 81 abgelegt. Das zu prüfende bzw. zu korrigierende Datenwort Y befindet sich in einem Speicher 82, während das zugehörige Zuverlässigkeitswort Q bei 83 abgelegt ist.

Ein Abwärtszähler 84 wird auf einen Anfangswert n₀ gesetzt, wozu die Zahl F der Unzuverlässigkeitsbits aus der Schaltung 20 (Fig. 1) übernommen wird und n₀ nach der Gleichung 2^{F}-1 berechnet wird. In einem Adressengenerator 85 werden gemäß der Tabelle in Fig. 3 durch Anwendung des Gray-Codes Adressen zum Auslesen der Syndrome S₁ bis S_{F} aus dem Speicher 81 gewonnen.

Eine Exklusiv-Oder-Schaltung 86 verknüpft das jeweils ihr zugeführte Syndrom mit dem im Akkumulator 87 gespeicherten Syndrom und schreibt das erhaltene Syndrom in den Akkumulator 87 ein. Der Inhalt des Akkumulators 87 wird mit Hilfe eines Komparators 88 mit dem Wert 0 verglichen, der über einen Umschalter 98 zugeführt wird. Sobald ein Syndrom oder eine Kombination von Syndromen im Akkumulator 87 den Wert 0 aufweist, wird vom Komparator ein Signal abgegeben, welches den Abbruch der Operation bedeutet.

Die Operation wird ferner abgebrochen, wenn der Inhalt des Akkumulators 87 für den Fall x>1 (siehe Fig. 4) gleich einer Zeile der K-Matrix 99 ist. Dazu wird der Umschalter in die linke Stellung gebracht, worauf die Zeilen der K-Matrix 99 nacheinander ausgelesen werden.

Der Inhalt des Komparators 87 wird ferner mit dem Syndrom S_{Y} verglichen, welches in einer Schaltung 89 aus dem Datenwort Y nach dem in Fig. 2 dargestellten Rechenverfahren gewonnen wird. Zum Vergleich des Akkumulatorinhalts und des Syndroms S_{Y} ist ein 10-Bit-Komparator 90 vorgesehen, dessen Ausgang mit einem Speicher 91 verbunden ist, in welchem ein Merker (Flag) sowie eine Zahl m gespeichert werden können. Die Zahl m stellt denjenigen Stand des Zählers 84 dar, bei welchem der Inhalt des Akkumulators 87 gleich dem Syndrom S_{Y} ist, und markiert somit diejenige Kombination von Unzuverlässigkeitsbits, welche zur Gleichheit zwischen A und S_{Y} geführt haben.

Die zeitlichen Vorgänge beim Betrieb der Anordnung nach Fig. 6 werden von einer Ablaufsteuerung 92 gesteuert. Dieser wird unter anderem vom Zähler 84 ein Signal zugeführt, wenn der Zählerstand n gleich 1 ist. Wird dieses erreicht, ohne daß der Inhalt A des Akkumulators 87 den Wert 0 erreicht hat und das Flag gleich 0 ist, so wird von der Ablaufsteuerung 92 der Dual/Gray-Converter 93 aktiviert, welcher die Zahl m nach dem Gray-Code umwandelt und der Ablaufsteuerung 92 zuführt. Diejenigen Bits des Zuverlässigkeitswortes Q, welche auf korrekturfähige Bits des Wortes Y hinweisen, werden dadurch festgelegt. Ein diese Bits umfassender Korrekturwert K_{X} wird in der Schaltung 94 erzeugt. In der Schaltung 95 wird K_{X} in K_{Y} umgewandelt und in der Korrekturschaltung 96 mit dem Datenwort Y exklusiv-oder-verknüpft, welche an ihrem Ausgang 97 ein korrigiertes Datenwort Y_{K} abgibt.

## Patentansprüche

1. Gerät zum Empfang von Daten, die mittels Radiowellen, insbesondere zusammen mit anderen Informationen, übertragen werden,
wobei die Daten von binären Ausgangssignalen einer Schwellwertschaltung, die einem Demodulator nachgeschaltet ist, dargestellt werden,
wobei jeweils ein Datenwort aus einem Informationswort und einem Prüfwort besteht,
wobei aus dem empfangenen Datenwort (y) und einer Paritätsprüfmatrix ein Syndrom (S_{y}) gebildet wird, welches zur Fehlerfeststellung und gegebenenfalls Fehlerkorrektur angewendet wird, und
wobei ein binäres Zuverlässigkeitssignal abgeleitet wird, bei welchem jeweils ein Bit innerhalb eines Zuverlässigkeitswortes einem Bit des Datenwortes zugeordnet ist, dadurch gekennzeichnet, daß eine Fehlerkorrektur nicht durchgeführt wird, wenn eine aus diesem Zuverlässigkeitswort gebildete Kombination von mindestens zwei Syndromen den Wert einer Zeile der Paritätsprüfmatrix (H; K) aufweist.

2. Gerät nach Anspruch 1, dadurch gekennzeichnet, daß bei mit einer differenziellen Codierung übertragenen Datenwörtern eine Paritätsprüfmatrix (K) angewendet wird, die eine Zeile mehr aufweist als das übertragene Datenwort Bits.

3. Gerät nach Anspruch 1, dadurch gekennzeichnet, daß unter Anwendung derjenigen Bits (Unzuverlässigkeitsbits) des Zuverlässigkeitswortes, die denjenigen Wert aufweisen, der eine Unzuverlässigkeit des betreffenden Bits des Datenwortes bedeutet, weitere Syndrome gebildet werden, daß alle Kombinationen der weiteren Syndrome exklusiv-oder-verknüpft werden,
daß das empfangene Datenwort für ungültig erklärt wird, wenn entweder mindestens eine der Kombinationen der weiteren Syndrome den Wert 0 ergibt oder wenn mindestens eine der Kombinationen mindestens zweier Syndrome einer Zeile der Paritätsprüfmatrix entspricht,
daß die Richtigkeit des Datenwortes festgestellt wird, wenn keine der Kombinationen der weiteren Syndrome 0 ergibt und das Syndrom des Datenwortes gleich 0 ist,
daß eine Unkorrigierbarkeit des Datenwortes festgestellt wird, wenn keine der Kombinationen der weiteren Syndrome den Wert 0 ergibt und das Syndrom des Datenwortes sowohl ungleich 0 ist als auch von allen Kombinationen der weiteren Syndrome verschieden ist, und
daß das Datenwort korrigiert wird, wenn sowohl alle Kombinationen der weiteren Syndrome als auch das vom Datenwort abgeleitete Syndrom ungleich 0 sind und ferner eine Kombination der weiteren Syndrome gleich dem vom Datenwort abgeleiteten Syndrom ist.

4. Gerät nach Anspruch 3, dadurch gekennzeichnet,
daß die weiteren Syndrome aus einem Speicher gelesen werden, wobei dem Speicher Adressen zugeführt werden, welche jeweils aus der Position eines der Unzuverlässigkeitsbits innerhalb des Zuverlässigkeitswortes abgeleitet werden,
daß die Exklusiv-Oder-Verknüpfung der weiteren Syndrome nach einer derartigen Reihenfolge durchgeführt wird,
daß eine die Auswahl der jeweils zu verknüpfenden weiteren Syndrome darstellende Binärzahl sich jeweils nur in einer Binärstelle ändert (Gray-Code),
daß bei der Prüfung der Kombinationen der weiteren Syndrome eine Zählvariable verwendet wird, aus welcher nach einem Gray-Code die zu kombinierenden Syndrome ausgewählt werden,
daß bei dem höchsten, sich aus der Anzahl der Unzuverlässigkeitsbits ergebenden Zählwert begonnen und abwärts gezählt wird und
daß eine Prüfung , ob eine Kombination einer Zeile der Paritätsprüfmatrix entspricht, nur erfolgt, wenn die Anzahl der Einsen in der Zählvariablen größer als 1 ist.

## Claims

1. Apparatus for receiving data which is transmitted by means of radio waves, in particular together with other information,
the data being made up of output signals of a threshold value circuit which is connected downstream of a demodulator,
in each case a data word comprising an information word and a check word,
a syndrome (Sy) being formed from the received data word (y) and a parity check matrix, and being used to detect, and if appropriate correct, faults, and
a binary reliability signal being derived, at which in each case a bit within a reliability word is assigned to a bit of the data word, characterized in that a fault correction is not carried out if a combination, formed from this reliability word, of at least two syndromes has the value of one row of the parity check matrix (H; K).

2. Apparatus according to Claim l, characterized in that in the case of data words which are transmitted with differential coding, a parity check matrix (K) is used which has one row more than the transmitted data word bits.

3. Apparatus according to Claim l, characterized in that further syndromes are formed using those bits (unreliability bits) of the reliability word which have that value which signifies unreliability of the respective bit of the data word, in that exclusive-OR operations are carried out on all the combinations of the further syndromes, in that the received data word is declared invalid if either at least one of the combinations of the further syndromes yields the value 0 or if at least one of the combinations of at least two syndromes corresponds to one row of the parity check matrix, in that the correctness of the data word is determined if none of the combinations of the further syndromes yields 0 and the syndrome of the data word is equal to 0, in that the data word is determined as being uncorrectable if none of the combinations of the further syndromes yields the value 0 and the syndrome of the data word is both unequal to 0 and is different from all the combinations of the further syndromes, and in that the data word is corrected if both all the combinations of the further syndromes and the syndrome derived from the data word are unequal to 0 and in addition a combination of the further syndromes is equal to the syndrome derived from the data word.

4. Apparatus according to Claim 3, characterized in that the further syndromes are read out of a memory, addresses which are each derived from the position of one of the unreliability bits within the reliability word being fed to the memory, in that the exclusive-OR operation carried out on the further syndromes is performed according to such a sequence that a binary number which represents the selection of the respective further syndromes to be logically linked only changes by one binary position in each case (Gray code), in that when the combinations of the further syndromes are checked, a counting variable is used from which the syndromes to be combined are selected according to a Gray code, in that the highest counting value resulting from the number of unreliability bits is started at and counted down from, and in that a check to determine whether a combination corresponds to a row of the parity check matrix only takes place if the number of ones in the counting variable is greater than 1.

## Revendications

1. Appareil pour recevoir des données transmises par des ondes radio, notamment avec d'autres informations,
les données étant représentées par des signaux binaires de sortie d'un circuit à seuil suivi d'un démodulateur,
chaque mot de données se compose d'un mot d'information et d'un mot de contrôle,
à partir du mot de données reçu (Y) et d'une matrice de contrôle de parité, on forme un syndrome (Sy) utilisé pour constater les défauts et, le cas échéant, corriger les défauts,
on déduit un signal binaire de fiabilité dans lequel chaque fois un bit contenu dans un mot de fiabilité est associé à un bit des mots de données,
caractérisé en ce qu'on n'effectue pas de correction d'erreur si une combinaison d'au moins deux syndromes, formée à partir de ce mot de fiabilité, présente la valeur d'une ligne de la matrice de contrôle de parité (H; K).

2. Appareil selon la revendication 1,
caractérisé en ce que
pour des mots de données transmis avec un codage différentiel, on utilise une matrice de contrôle de parité (K) qui comporte une ligne de plus que les bits du mot de données transmis.

3. Appareil selon la revendication 1,
caractérisé en ce que
en utilisant chaque fois les bits (bits de non-fiabilité) du mot de fiabilité, ayant la valeur qui signifie une non-fiabilité du bit concerné du mot de données, on forme d'autres syndromes,
toutes les combinaisons des autres syndromes sont soumises à une combinaison ou-exclusif,
le mot de données reçu est déclaré non valable si au moins soit l'une des combinaisons des autres syndromes donne la valeur 0 ou si au moins soit l'une des combinaisons correspond à au moins deux syndromes d'une ligne de la matrice de contrôle de parité,
on constate que le mot de données est correct si aucune des combinaisons des autres syndromes ne donne la valeur 0 et si le syndrome du mot de données est égal à 0,
on considère que le mot de données ne peut être corrigé si aucune des combinaisons des autres syndromes ne donne la valeur 0 et si le syndrome du mot de données est à la fois différent de 0 et différent de toutes les combinaisons des autres syndromes et,
on corrige le mot de données si à la fois toutes les combinaisons des autres syndromes et le syndrome déduit du mot de données sont différents de 0 et si, en outre, une combinaison des autres syndromes est égale au syndrome déduit du mot de données.

4. Appareil selon la revendication 3,
caractérisé en ce que,
les autres syndromes sont lus dans une mémoire, cette mémoire recevant des adresses déduites chaque fois de la position de l'un des bits de non-fiabilité à l'intérieur du mot de fiabilité,
la combinaison ou-exclusif des autres syndromes est effectuée suivant un ordre tel qu'un nombre binaire représentant la sélection des autres syndromes chaque fois à combiner ne change chaque fois que pour une position binaire (Code de Gray),
en contrôlant les combinaisons des autres syndromes, on utilise une variable de comptage dans laquelle on sélectionne les syndromes à combiner selon un code de Gray,
on commence pour la valeur de comptage la plus élevée qui résulte du nombre de bits de non-fiabilité, et on décompte et,
on effectue un contrôle pour savoir si une combinaison correspond à une ligne de la matrice de contrôle de parité, seulement si le nombre des états 1 dans les variables de comptage est supérieur à 1.
